**Europäisches Patentamt**

(19) **European Patent Office**

**Office européen des brevets**

(11) Veröffentlichungsnummer: **0 177 869**
**B1**

(12) **EUROPÄISCHE PATENTSCHRIFT**

(45) Veröffentlichungstag der Patentschrift:
16.08.89

(51) Int. Cl.⁴: **G 01 N 24/06, H 01 F 27/36**

(21) Anmeldenummer: 85112377.8

(22) Anmeldetag: 30.09.85

(54) Magneteinrichtung einer Anlage zur Kernspin-Tomographie mit Abschirmung.

(30) Priorität: 12.10.84 DE 3437529

(43) Veröffentlichungstag der Anmeldung:
16.04.86 Patentblatt 86/16

(45) Bekanntmachung des Hinweises auf die Patenterteilung:
16.08.89 Patentblatt 89/33

(84) Benannte Vertragsstaaten:
DE FR GB NL

(56) Entgegenhaltungen:
EP-A- 0 111 219
EP-A- 0 139 308
DE-U- 7 427 707
US-A- 4 156 862

(73) Patentinhaber: Siemens Aktiengesellschaft,
Wittelsbacherplatz 2, D-8000 München 2 (DE)

(72) Erfinder: Ries, Günter, Dr., Schobertweg 2,
D-8520 Erlangen (DE)

ACTORUM AG

## Beschreibung

Gegenstand der nicht vorveröffentlichten deutschen Patentanmeldung DE-A 3 333 755 ist eine besondere Magneteinrichtung einer Anlage zur Kernspin-Tomographie, die mit mehreren Magnetspulen versehen ist, welche einen zur Aufnahme eines zu untersuchenden Körpers geeigneten Innenraum umschließen und in diesem ein zumindest weitgehend homogenes Magnetfeld erzeugen. Die Spulen sind dabei von einer annähernd zylinderförmigen Abschirmvorrichtung aus ferromagnetischem Material umgeben, die mindestens vier baugleiche, in Umfangsrichtung auf einer gemeinsamen Zylindermantelfläche regelmäßig verteilt angeordnete balkenartige Abschirmelemente und an ihren stirnseitigen Enden je ein scheibenförmiges Bauteil mit einer zentralen Öffnung mit vorbestimmtem Radius bezüglich der Zylinderachse aufweist.

Kernspin-Tomographie-Anlagen (Nuclear-Magnetic-Resonance-[NMR]-Anlagen) zur medizinischen Diagnostik sind allgemein bekannt (vgl. z.B. EP-A 21 535 oder DE-A 2 921 252). Derartige Anlagen weisen eine Magneteinrichtung mit einer Anordnung von normal- oder insbesondere supraleitenden Feldspulen auf, mit denen ein möglichst starkes Grundfeld hervorzurufen ist, das in einem Meßbereich eine hinreichend hohe Homogenität aufweist. Dieses Grundfeld ist von gepulsten Gradientenfeldern überlagert. Außerdem muß ein senkrecht zu dem Grundfeld orientiertes Hochfrequenzfeld vorgesehen werden. Die Abmessungen der entsprechenden Spulen sind dabei den Dimensionen des zu untersuchenden Körpers so anzupassen, daß dieser in den Meßbereich innerhalb eines von den Spulen umgebenen Innenraumes ohne weiteres eingeschoben werden kann.

Das starke Magnetfeld einer derartigen Spulenanordnung soll sich im wesentlichen nur in dem Meßbereich befinden, sich aber möglichst nicht in Form eines Streufeldes in die Umgebung der Spulenanordnung ausbreiten, wo es z.B. zu Störungen in bestimmten elektromagnetischen Geräten führen oder auch eine unerwünschte Kraftwirkung auf ferromagnetische, bewegliche Teile ausüben kann. Eine Magneteinrichtung zur Kernspin-Tomographie weist deshalb neben der Spulenanordnung zweckmäßigerweise auch eine besondere Abschirmvorrichtung auf, um das Streufeld außerhalb der Spulenanordnung begrenzt zu halten.

Mit der mit der genannten Patentanmeldung vorgeschlagenen Abschirmvorrichtung ist eine weitgehende Rückführung des magnetischen Flusses um die Spulenanordnung der Magneteinrichtung zu gewährleisten. So kann mit einer derartigen Vorrichtung das Streufeld eines z.B. 1-Tesla-Magneten um einen Abschirmfaktor von etwa 4 bis 5 verringert werden. Quellen eines magnetischen Streuflusses sind jedoch hauptsächlich die stirnseitigen, zentralen Öffnungen in den scheibenförmigen Endplatten dieser Abschirmvorrichtung, wobei der Öffnungsdurchmesser durch die Forderung nach Feldhomogenität auf einen vorbestimmten Radius von beispielsweise etwa 1.65 m festgelegt ist und somit beliebig verkleinert werden kann.

Aufgabe der Erfindung ist es, die vorgeschlagene Abschirmvorrichtung dahingehend zu verbessern, daß mit ihr eine weitere Reduzierung des Streuflusses ermöglicht wird.

Diese Aufgabe wird erfindungsgemäß dadurch gelöst, daß an jedem der beiden stirnseitigen Enden der Abschirmvorrichtung zusätzlich zwei Abschirmplatten parallel zueinander so angeordnet sind, daß sie jeweils zwei der balkenartigen Abschirmelemente in Längsrichtung über das entsprechende scheibenförmige Bauteil hinaus um ein vorbestimmtes Maß verlängern.

Mit derartigen achsenparallel ausgerichteten Abschirmplatten aus ferromagnetischem Material läßt sich vorteilhaft der Streufluß möglichst dicht am Austrittsort der zentralen Öffnungen in den scheibenförmigen Bauteilen (Endplatten) einfangen und auf die jeweils gegenüberliegende Seite über den zylindermantelförmigen Teil der Abschirmvorrichtung zurückführen. Zugleich kann auch die Menge an ferromagnetischem Material und somit das Gewicht der zusätzlichen Abschirmplatten entsprechend begrenzt gehalten werden.

Eine weitere Lösung der genannten Aufgabe besteht darin, daß zusätzlich mindestens zwei in zwei parallelen Ebenen liegende langgestreckte Abschirmplatten vorgesehen sind, die parallel und beabstandet zu den balkenförmigen Abschirmelementen der Abschirmvorrichtung angeordnet sind und die um ein vorbestimmtes Maß über die jeweiligen stirnseitigen Enden hinausragen. Hierbei können in jeder der beiden parallelen Ebenen mindestens zwei Abschirmplatten liegen, deren gegenseitiger Abstand der entsprechenden Breite der zylinderförmigen Abschirmvorrichtung angepaßt ist. Daneben kann in jeder Ebene auch nur eine Abschirmplatte vorgesehen werden, deren Breite zumindest weitgehend der Breite der zylinderförmigen Abschirmvorrichtung entspricht.

Auch mit diesen zusätzlichen Abschirmplatten läßt sich vorteilhaft eine effektive Reduzierung des an den Stirnseiten der zylinderförmigen Abschirmvorrichtung austretenden Streuflusses erreichen.

Vorteilhafte Ausgestaltungen der Magneteinrichtung nach der Erfindung gehen aus den übrigen Unteransprüchen hervor.

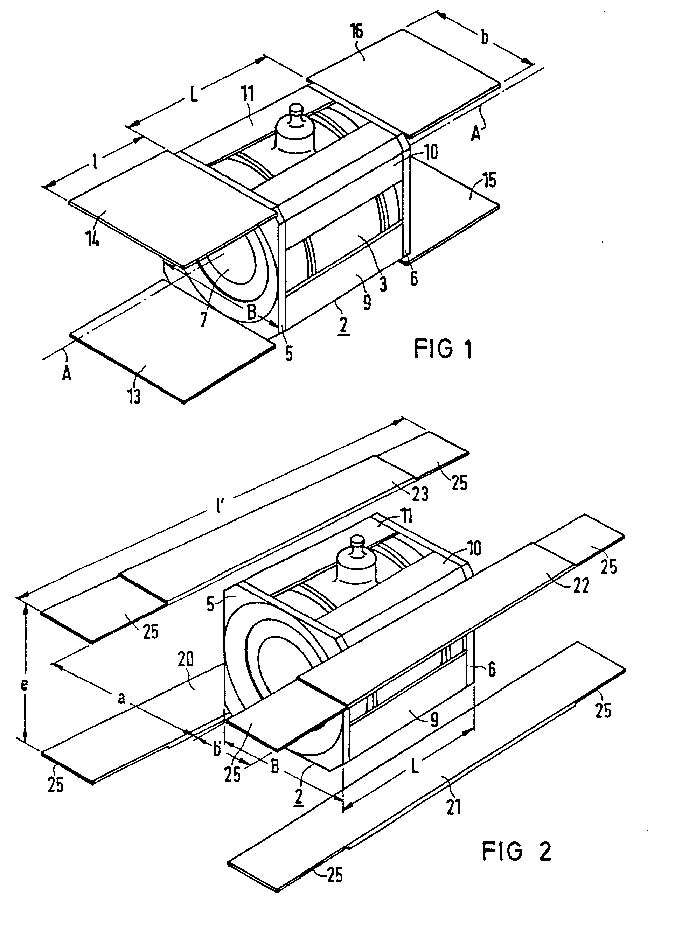

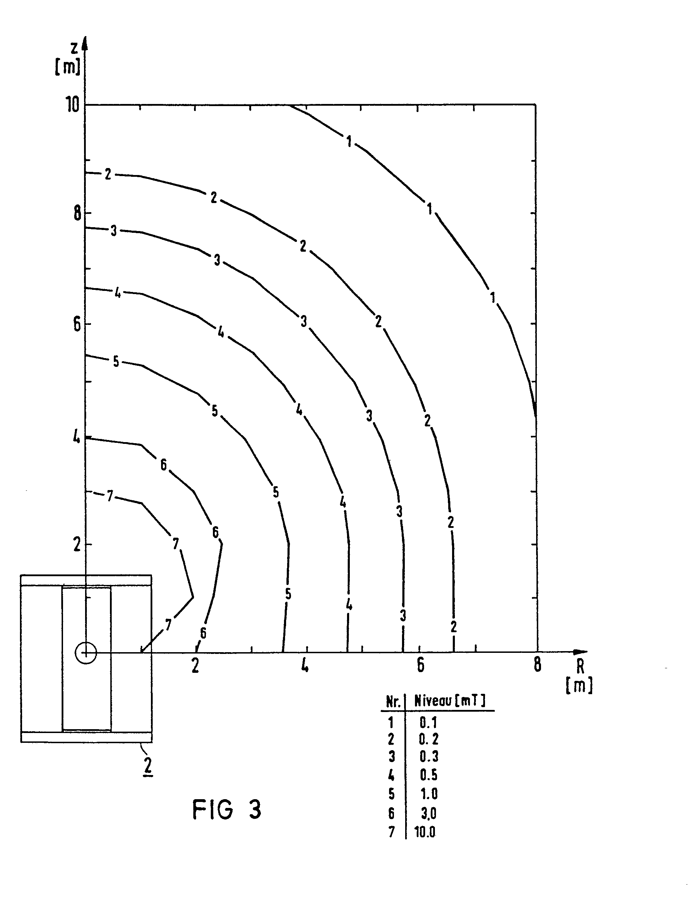

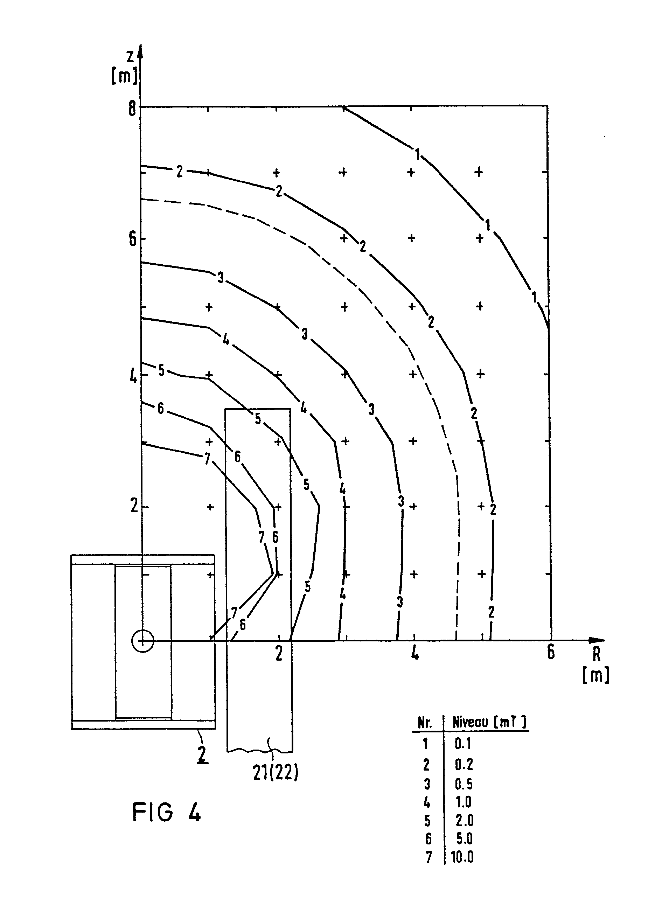

Zur weiteren Erläuterung der Erfindung wird nachfolgend auf die Zeichnung verwiesen, in deren Figur 1 eine Magneteinrichtung mit einer erfindungsgemäßen Abschirmung in Schrägsicht veranschaulicht ist. Figur 2 zeigt eine weitere Ausführungsform einer erfindungsgemäßen Abschirmung in entsprechender Darstellung. In den Diagrammen der Figuren 3 und 4 ist das Streufeld um eine Magneteinrichtung ohne Abschirmung bzw. mit einer Abschirmung nach Figur 2 wiedergegeben.

Bei den veranschaulichten Magneteinrichtungen nach der Erfindung wird von bekannten Kernspin-Tomographie-Anlagen (NMR-Anlagen) ausgegangen. Diese Magneteinrichtungen umfassen neben einer Anordnung von mehreren Magnetspulen jeweils auch besondere Maßnahmen zur Abschirmung bzw. Flußrückführung.

Ein Ausführungsbeispiel einer entsprechenden Abschirmung ist in Figur 1 angedeutet. Hierbei ist

eine zylinderförmige Abschirmvorrichtung zugrundegelegt, wie sie mit der deutschen Patentanmeldung DE-A 3 333 755 vorgeschlagen wurde. Diese allgemein mit 2 bezeichnete Vorrichtung umschließt einen Kryostaten 3, in dem supraleitende Magnetspulen zur Erzeugung eines homogenen Grundfeldes mit einer magnetischen Flußdichte von z.B. 1 T oder höher angeordnet sind. An den Stirnseiten des Kryostaten 3 sind als Endpole massive Platten 5 und 6 mit jeweils einer runden zentralen Öffnung 7 vorgesehen. Der Radius der zentralen Öffnung 7 in den annähernd als gleichseitige Vierecke gestalteten Endplatten 5 und 6 ist so gewählt, daß einerseits ein ausreichender Zugang in das Innere der Magneteinrichtung gestattet und andererseits der Feldfehler im Nutzvolumen um das Spulenzentrum minimal wird. Er ist somit festgelegt und kann nicht ohne weiteres zur Verringerung des austretenden Streuflusses verkleinert werden, da sonst ein erheblicher Feldfehler des Grundfeldes die Folge wäre.

Die stirnseitigen Endplatten 5 und 6 der Abschirmvorrichtung 2 sind über vier in Längsrichtung, d.h. parallel zu der zentralen Magnetfeldachse A verlaufende balkenförmige Abschirmelemente miteinander magnetisch leitend verbunden. In der Darstellung der Figur sind nur drei dieser Elemente ersichtlich und mit 9 bis 11 bezeichnet. Diese Elemente liegen untereinander regelmäßig verteilt auf einer gedachten Zylindermantelfläche, die konzentrisch um die Achse A angeordnet ist. Sie haben vorzugsweise alle gleiche Gestalt und können eine beliebige Querschnittsform haben, z.B. rechteckig sein. Insbesondere weisen sie jedoch zumindest annähernd die Querschnittsform rechtwinkliger Dreiecke auf. Dabei können gemäß dem dargestellten Ausführungbeispiel die äußeren Spitzen dieser Dreiecke abgeschnitten sein, so daß trapezförmige Querschnitte erhalten werden.

Zusammen mit den etwa quadratischen Endplatten 5 und 6 bilden die balkenförmigen Abschirmelemente ein starres, selbsttragendes Gerüst. dessen Querabmessungen im Falle einer 1-T-Magnetspulenanordnung kaum größer als der Außendurchmesser dieser Spulen bzw. des Kryostaten 3 ist. Mittels der durch dieses Gerüst gebildeten zylinderförmigen Abschirmvorrichtung 2 wird der an den Stirnseiten austretende magnetische Fluß zurückgeführt und so das Streufeld wesentlich verringert. Gemäß der Erfindung läßt sich dieser an den Stirnseiten austretende Streufluß durch zusätzliche Abschirmplatten einfangen, die, um wirksam zu sein, möglichst nahe an den stirnseitigen Austrittsstellen des Streuflusses angeordnet sein und den Fluß auf die gegenüberliegende Seite führen können müssen.

Gemäß dem in Figur 1 gezeigten Ausführungsbeispiel sind vier zusätzliche Abschirmplatten 13 bis 16 vorgesehen. Jeweils zwei dieser parallel zueinander angeordneten Platten 13, 14 oder 15, 16 sind an einer der beiden stirnseitigen Endplatten 5 oder 6 so angebracht. daß sie zwei der balkenförmigen Abschirmelemente der zylinderförmigen Abschirmvorrichtung 2 in Achsrichtung über die jeweilige Endplatte hinaus verlängern. Dementsprechend erstrecken sich beispielsweise zwischen den beiden in einer Ebene liegenden, am Außenrand der Endplatten 5 und 6 befestigten zusätzlichen Abschirmplatten 14 bzw. 16 die beiden balkenförmigen Abschirmelemente 10 und 11 in Längsrichtung. In entsprechender Weise sind auch die Abschirmplatten 13 und 15 mit den Endplatten 5 und 6 und somit mit den entsprechenden balkenförmigen Abschirmelementen verbunden. Dabei beträgt die Längsausdehnung l der zusätzlichen Abschirmplatten 13 bis 16 vorteilhaft mindestens die Hälfte der Längsausdehnung L der zylinderförmigen Abschirmvorrichtung 2. Im allgemeinen braucht die Länge l für eine effektive Reduzierung des Streuflusses nicht länger als ¾ der Länge L zu sein. Günstig ist es z.B., wenn l gleich ⅔ × L gewählt wird. Die Breite b der Platten entspricht dabei zumindest in etwa der entsprechenden Breite B der Endplatten 5 und 6, während ihre Dicke einige cm beträgt und beispielsweise bei 1 bis 2 cm liegt.

Gemäß einem konkreten Ausführungsbeispiel hat die Abschirmvorrichtung 2 eine axiale Länge L von 2,6 m und eine Breite B von 2,2 m. Die 2 cm starken Abschirmplatten 13 bis 16 mit entsprechender Breite b haben jeweils eine axiale Ausdehnung l von 1,7 m und liegen direkt an den entsprechenden Außenrändern der jeweiligen Endplatten an. Mit einer derartigen zusätzlichen Abschirmung läßt sich das Streufeld zusätzlich um einen Faktor 0,7 gegenüber dem Streufeld ohne Abschirmplatten verringern.

Eine weitere Reduzierung des Streufeldes gegenüber den in Figur 1 gezeigten zusätzlichen Maßnahmen ist mit der in Figur 2 veranschaulichten Abschirmung zu erreichen. Diese Einrichtung enthält neben der etwa zylinderförmigen Abschirmvorrichtung 2 gemäß Figur 1 mit vier balkenförmigen Abschirmelementen (9 bis 11) und stirnseitigen Endplatten (5, 6) vier zusätzliche Abschirmplatten 20 bis 23. Gegenüber den als Fortsätzen gestalteten zusätzlichen Abschirmplatten 13 bis 16 nach Figur 1 sind bei dieser Ausführungsform die Fortsätze längsgeteilt. waagrecht auseinandergezogen und in Achsrichtung weiter verlängert. Außerdem wird der eingefangene Streufluß nicht mehr über die zylinderförmige Abschirmvorrichtung selbst geleitet. Die so entstandene Struktur in Form von vier achsparallelen Platten kann deshalb auch als eine zweite Flußrückführung neben der der zylinderförmigen Abschirmvorrichtung betrachtet werden. Dementsprechend sind die vier langgestreckten Abschirmplatten parallel und möglichst nahe zu den balkenförmigen Abschirmelementen angeordnet, ohne mit diesen magnetisch leitend verbunden zu sein. Dabei kommen in zwei parallelen Ebenen jeweils zwei der Abschirmplatten, nämlich die Platten 20 und 21 bzw. 22 und 23 mit einem gegenseitigen Abstand a zu liegen. Dieser Abstand zwischen den in einer Ebene befindlichen Abschirmplatten ist durch die entsprechenden Abmessungen der zylinderförmigen Abschirmvorrichtung 2 bestimmt und beträgt beispielsweise etwas mehr als deren Breite B. In gleicher Weise ist die Entfernung e zwischen den parallelen Ebenen. in denen sich jeweils zwei der Abschirmplatten befinden. bestimmt. Die gesamte Länge l' der Abschirmplatten 20 bis 23 sollte mindestens ⅞ der axialen Länge L der zylinderförmigen Abschirmvorrichtung 2 sein und höchstens etwa das 3fache dieser Länge betragen. Vorteilhaft ist ein Wert für l' von etwa 2,7 × L. Die Breite b' der Abschirmplatten wird zweckmäßigerweise zwischen 0,5 und 1,5 m gewählt.

Gemäß einem konkreten Ausführungsbeispiel einer Abschirmvorrichtung nach Figur 2 für eine etwa zylinderförmige Abschirmvorrichtung 2 entsprechend dem Ausführungsbeispiel zur Figur 1 werden Abschirmplatten 20 bis 23 mit einer Länge l' von 7 m und mit einer Breite b' von einem Meter vorgesehen. Diese Platten sind bis auf ihre stirnseitigen, jeweils 1,5 m langen Endstücke 25 etwa 2 cm stark, während ihre Dicke im Bereich dieser Endstücke 25 hauptsächlich aus Gewichtsgründen auf 1 cm reduziert ist. Die in jeweils einer Ebene liegenden Platten sind untereinander um einen Abstand a von 2,4 m beabstandet, während die Entfernung e zwischen den jeweils 2 Abschirmplatten umfassenden Ebenen etwa 2,35 m beträgt. Mit einer derartigen Abschirmung läßt sich etwa die Hälfte des an den Stirnseiten aus der käfigartigen Abschirmvorrichtung austretenden Streuflusses auffangen.

In Figur 3 ist in einem Quadranten eines Diagrammes das Streufeld um einen 1-T-Kernspintomographie-Magneten veranschaulicht, der lediglich mit einer etwa zylinderförmigen Abschirmvorrichtung 2 gemäß dem Ausführungsbeispiel nach Figur 1 oder 2 versehen ist. Dabei ist auf der Ordinate z die Entfernung vom Zentrum des Magneten in Richtung der Magnetfeldachse A und auf der Abszisse R die zugehörige Entfernung in radialer Richtung jeweils in Metern angegeben. Die Lage der Abschirmvorrichtung 2 ist außerdem in das Diagramm mit eingetragen. Aus dem Diagramm sind sieben Konturlinien 1 bis 7 ersichtlich, die gemäß der in dieser Figur wiedergegebenen Tabelle bestimmten, in Millitesla angegebenen Feldniveaus entsprechen.

In entsprechender Darstellung ist auch in Figur 4 in einem Diagramm das Streufeld um einen 1-T-Kernspintomographie-Magneten mit der etwa zylinderförmigen Abschirmvorrichtung 2 durch einzelne Feldniveau-Konturlinien veranschaulicht. Im Gegensatz zu Figur 3 ist hier jedoch eine Abschirmung vorgesehen, die neben der Abschirmvorrichtung 2 noch langgestreckte Abschirmplatten gemäß dem konkreten Ausführungsbeispiel zu Figur 2 umfaßt. Aus dem Vergleich der Diagramme der Figuren 3 und 4 ist dann abzulesen, daß mit der Zusatzabschirmung mittels der Abschirmplatten eine wesentliche Reduzierung des Streufeldes zu erreichen ist.

Bei dem in Figur 2 dargestellten Ausführungsbeispiel einer erfindungsgemäßen Abschirmung wurde davon ausgegangen, daß in zwei parallelen Ebenen jeweils zwei zusätzliche Abschirmplatten (20, 21 bzw. 22, 23) vorgesehen sind, die einerseits zu den zugeordneten balkenförmigen Abschirmelementen (9 bis 11) der etwa zylinderförmigen Abschirmvorrichtung (2) und andererseits untereinander um ein vorbestimmtes Maß (a) beabstandet angeordnet sind. Statt dieser somit vier zusätzlichen Abschirmplatten kann man jedoch in den beiden achsenparallelen Ebenen über und unter der Abschirmvorrichtung (2) auch nur je eine breitere Abschirmplatte anbringen, wobei dann deren jeweilige Breite in etwa der Breite der Abschirmvorrichtung entspricht.

Den Ausführungsbeispielen nach den Figuren wurde eine etwa zylinderförmige Abschirm- bzw. Flußrückführungsvorrichtung zugrundegelegt, deren vier balkenförmigen Abschirmelemente etwa dreiecks- oder trapezartige Querschnitte aufweisen. Ebensogut sind die zusätzlichen Abschirmmaßnahmen gemäß den Figuren 1 und 2 auch für Flußrückführungsvorrichtungen geeignet, deren balkenförmige Abschirmelemente andere Querschnitte aufweisen.

## Patentansprüche

1. Magneteinrichtung einer Anlage zur Kernspin-Tomographie mit mehreren Magnetspulen, welche einen zur Aufnahme eines zu untersuchenden Körpers geeigneten Innenraum umschließen und in diesem ein zumindest weitgehend homogenes Magnetfeld erzeugen, und mit einer die Spulen umgebenden, annähernd zylinderförmigen Abschirmvorrichtung aus ferromagnetischem Material, die mindestens vier baugleiche, in Umfangsrichtung auf einer gemeinsamen Zylindermantelfläche regelmäßig verteilt angeordnete balkenartige Abschirmelemente und an ihren stirnseitigen Enden je ein scheibenförmiges Bauteil mit einer zentralen Öffnung mit vorbestimmtem Radius bezüglich der Zylinderachse aufweist. dadurch gekennzeichnet, daß an jedem der beiden stirnseitigen Enden (Endplatten 5 und 6) der Abschirmvorrichtung (2) zusätzlich zwei Abschirmplatten (13. 14 bzw. 15, 16) parallel zueinander so angeordnet sind. daß sie jeweils zwei der balkenartigen Abschirmelemente (9 bis 11) in Längsrichtung über das entsprechende scheibenförmige Bauteil (Endplatte 5 bzw. 6) hinaus um ein vorbestimmtes Maß (Länge l) verlängern.

2. Magneteinrichtung nach Anspruch 1, dadurch gekennzeichnet, daß die zusätzlichen Abschirmplatten (13 bis 16) in gegenüberliegenden Aussenbereichen des jeweiligen scheibenförmigen Bauteiles (Endplatte 5 bzw. 6) an diesem angebracht sind.

3. Magneteinrichtung nach Anspruch 1 oder 2, dadurch gekennzeichnet, daß die axiale Länge (l) der zusätzlichen Abschirmplatten (13 bis 16) mindestens die Hälfte der entsprechenden Ausdehnung (Länge L) der zylinderförmigen Abschirmvorrichtung (2) beträgt.

4. Magneteinrichtung nach einem der Ansprüche 1 bis 3, dadurch gekennzeichnet. daß die axiale Länge (l) der zusätzlichen Abschirmplatten (13 bis 16) höchstens ⅔ der entsprechenden Ausdehnung (Länge L) der zylinderförmigen Abschirmvorrichtung (2) beträgt.

5. Magneteinrichtung nach einem der Ansprüche 1 bis 4, dadurch gekennzeichnet, daß die Breite (b) der zusätzlichen Abschirmplatten (13 bis 16) zumindest weitgehend gleich der entsprechenden Breite (B) der zylinderförmigen Abschirmvorrichtung (2) ist.

6. Magneteinrichtung einer Anlage zur Kernspin-Tomographie mit mehreren Magnetspulen. welche einen zur Aufnahme eines zu untersuchenden Körpers geeigneten Innenraum umschließen und in diesem ein zumindest weitgehend homogenes Magnetfeld erzeugen, und mit einer die Spulen umgebenden. annähernd zylinderförmigen Abschirmvorrichtung aus ferromagnetischem Material, die mindestens vier baugleiche, in Umfangsrichtung auf einer gemeinsamen Zylindermantelfläche regelmäßig verteilt angeordnete balkenartige Abschirmelemente und an ihren stirnseitigen Enden je ein scheibenförmiges Bauteil mit einer zentralen Öffnung mit vorbestimmtem Radius bezüglich der Zylinderachse aufweist, dadurch gekennzeichnet, daß zusätzlich mindestens zwei in zwei parallelen Ebenen liegende langgestreckte Abschirmplatten (20 bis 23) vorgesehen sind, die parallel und beabstandet zu den balkenförmigen Abschirmelementen (9 bis 11) der Abschirmvorrichtung (2) angeordnet sind und die um ein vorbestimmtes Maß (Länge l' – Länge L) über die jeweiligen stirnseitigen Enden (Endplatten 5 und 6) hinausragen.

7. Magneteinrichtung nach Anspruch 6, dadurch gekennzeichnet, daß in jeder der beiden parallelen Ebenen mindestens zwei Abschirmplatten (20, 21 bzw. 22, 23) liegen, deren gegenseitiger Abstand (a) der entsprechenden Breite (B) der zylinderförmigen Abschirmvorrichtung (2) angepaßt ist.

8. Magneteinrichtung nach Anspruch 6, dadurch gekennzeichnet, daß in jeder der beiden parallelen Ebenen eine Abschirmplatte liegt, deren Breite zumindest weitgehend der Breite (B) der zylinderförmigen Abschirmvorrichtung (2) entspricht.

9. Magneteinrichtung nach einem der Ansprüche 6 bis 8, dadurch gekennzeichnet, daß die axiale Länge (l') der zusätzlichen Abschirmplatten (20 bis 23) mindestens ⅞ der entsprechenden Länge (L) der zylinderförmigen Abschirmvorrichtung (2) beträgt.

10. Magneteinrichtung nach einem der Ansprüche 6 bis 9, dadurch gekennzeichnet, daß die axiale Länge (l') der zusätzlichen Abschirmplatten (20 bis 23) höchstens das 3fache der entsprechenden Länge (L) der zylinderförmigen Abschirmvorrichtung (2) beträgt.

11. Magneteinrichtung nach einem der Ansprüche 6, 7, 9 oder 10, dadurch gekennzeichnet, daß die Breite (b') der zusätzlichen Abschirmplatten (20 bis 23) zwischen 0,5 und 1,5 m liegt.

12. Magneteinrichtung nach einem der Ansprüche 1 bis 11, dadurch gekennzeichnet, daß die Stärke (Dicke) der zusätzlichen Abschirmplatten (13 bis 16; 20 bis 23) zwischen 1 und 3 cm liegt.

13. Magneteinrichtung nach einem der Ansprüche 6 bis 12, dadurch gekennzeichnet, daß die Stärke (Dicke) der zusätzlichen Abschirmplatten (20 bis 23) im Bereich ihrer stirnseitigen Enden (25) geringer ist als im Bereich der zylinderförmigen Abschirmvorrichtung (2).

**Claims**

1. Magnet arrangement of an installation for nuclear spin tomography having several magnet coils which enclose an interior space suitable for receiving a body which is to be examined and generate in said space a magnetic field which is at least substantially homogeneous, and having a screening arrangement which surrounds the coils, is substantially cylindrical, is made of ferromagnetic material and has at least four bar-type screening elements, which are similar in construction and are arranged regularly distributed in the peripheral direction on a common cylinder lateral surface, and at each of its face ends a disk-shaped component with a central opening with predetermined radius relative to the cylinder axis, characterised in that at each of two face ends (end plates 5 and 6) of the screening arrangement (2) there are in addition two screening plates (13, 14 and 15, 16 respectively) arranged parallel to each other in such a way that they extend in each case two of the bar-type screening elements (9 to 11) in the longitudinal direction beyond the corresponding disk-shaped component (end plate 5 or 6) by a predetermined amount (length l).

2. Magnet arrangement according to claim 1, characterised in that the additional screening plates (13 to 16) are provided in opposite outer regions of the respective disk-shaped component (end plate 5 or 6) on said component.

3. Magnet arrangement according to claim 1 or 2, characterised in that the axial length (l) of the additional screenig plates (13 to 16) amounts to at least half the corresponding extension (length L) of the cylindrical screening arrangement (2).

4. Magnet arrangement according to one of the claims 1 to 3, characterised in that the axial length (l) of the additional screening plates (13 to 16) amounts at most to ⅔ of the corresponding extension (length L) of the cylindrical screening arrangement (2).

5. Magnet arrangement according to one of the claims 1 to 4, characterised in that the width (b) of the additional screening plates (13 to 16) is at least substantially equal to the corresponding width (B) of the cylindrical screening arrangement (2).

6. Magnet arrangement of an installation for nuclear spin tomography having several magnet coils which enclose an interior space suitable for receiving a body which is to be examined and generate in said space a magnetic field which is at least substantially homogeneous, and having a screening arrangement which surrounds the coils, is substantially cylindrical, is made of ferromagnetic material and has at least four bar-type screening elements, which are similar in construction and are arranged regularly distributed in the peripheral direction on a common cylinder lateral surface, and at each of its face ends a disk-shaped component with a central opening with predetermined radius relative to the cylinder axis, characterised in that in addition there are provided at least two longitudinally extended screening plates (20 to 23) which lie in two parallel planes and are arranged parallel to and at a distance from the bar-shaped screening elements (9 to 11) of the screening arrangement (2) and which jut out, by a predetermined amount (length l'–length L), over the respective face ends (end plates 5 and 6).

7. Magnet arrangement according to claim 6, characterised in that there lie in each of the two parallel planes at least two screening plates (20, 21 or 22, 23), the mutual spacing (a) of which is adapted to the corresponding width (B) of the cylindrical screening arrangement (2).

8. Magnet arrangement according to claim 6, characterised in that there lies in each of the two parallel planes a screening plate, the width of which corresponds at least substantially to the width (B) of the cylindrical screening arrangement (2).

9. Magnet arrangement according to one of the claims 6 to 8, characterised in that the axial length (l') of the additional screening plates (20 to 23) amounts to at least 7/8 of the corresponding length (L) of the cylindrical screening arrangement (2).

10. Magnet arrangement according to one of the claims 6 to 9, characterised in that the axial length (l') of the additional screening plates (20 to 23) amounts at most to three times the corresponding length (L) of the cylindrical screening arrangement (2).

11. Magnet arrangement according to one of the claims 6, 7, 9 or 10, characterised in that the width (b') of the additional screening plates (20 to 23) lies between 0.5 and 1.5 m

12. Magnet arrangement according to one of the claims 1 to 11, characterised in that the strength 16; 20 to 23) lies between 1 and 3 cm.

13. Magnet arrangement according to one of the claims 6 to 12, characterised in that the strength (thickness) of the additional screening plates (20 to 23) is smaller in the region of their face ends (25) than in the region of the cylindrical screening arrangement (2).

## Revendications

1. Dispositif magnétique d'une installation de tomographie à spin nucléaire comportant plusieurs bobines magnétiques qui entourent un espace intérieur convenant pour recevoir un corps à examiner et produisent, dans cet espace, un champ magnétique au moins dans une large mesure homogène, et avec un dispositif de blindage de forme approximativement cylindrique, qui entoure les bobines, qui est réalisé en un matériau ferromagnétique et qui comporte au moins quatre éléments identiques de blindage en forme de barres, répartis régulièrement dans la direction circonférentielle sur une surface enveloppe cylindrique commune, et des éléments respectifs en forme de disques, qui sont disposés sur les extrémités frontales de ces éléments de blindage et présentent une ouverture centrale de rayon prédéterminé par rapport à l'axe du cylindre, caractérisé par le fait que sur chacune des deux extrémités frontales (plaques d'extrémité 5 et 6) du dispositif de blindage (2) se trouvent en outre disposées deux plaques de blindage (13, 14 ou 15, 16) parallèles entre elles, qui prolongent respectivement deux des éléments de blindage en forme de barres (9 à 11) dans la direction longitudinale, sur une longueur prédéterminée (longueur l) au-delà de l'élément en forme de disque correspondant (plaque d'extrémité 5 ou 6).

2. Dispositif magnétique suivant la revendication 1, caractérisé par le fait que les plaques de blindage supplémentaires (13 à 16) sont montées sur l'élément respectif en forme de disque (plaque d'extrémité 5 ou 6), dans des zones extérieures opposées.

3. Dispositif magnétique suivant la revendication 1 ou 2, caractérisé par le fait que la longueur axiale (l) des plaques de blindage supplémentaires (13 à 16) est égale au moins à la moitié de l'étendue correspondante (longueur L) du dispositif de blindage de forme cylindrique (2).

4. Dispositif magnétique suivant l'une des revendications 1 à 3, caractérisé par le fait que la longueur axiale (1) des plaques de blindage supplémentaires (13 à 16) est égale au maximum aux 2/3 de l'étendue correspondante (longueur L) du dispositif de blindage de forme cylindrique (2).

5. Dispositif magnétique suivant l'une des revendications 1 à 4, caractérisé par le fait que la largeur (b) des plaques de blindage supplémentaires (13 à 16) correspond au moins dans une large mesure à largeur correspondante (B) du dispositif de blindage de forme cylindrique (2).

6. Dispositif magnétique d'une installation de tomographie à spin nucléaire comportant plusieurs bobines magnétiques qui entourent un espace intérieur convenant pour recevoir un corps à examiner et produisent, dans cet espace, un champ magnétique au moins dans une large mesure homogène, et avec un dispositif de blindage de forme approximativement cylindrique, qui entoure les bobines, qui est réalisé en un matériau ferromagnétique et qui comporte au moins quatre éléments identiques de blindage en forme de barres, répartis régulièrement dans la direction circonférentielle sur une surface enveloppe cylindrique commune, et des éléments respectifs en forme de disques, qui sont disposés sur les extrémités frontales de ces éléments de blindage et préminé par rapport à l'axe du cylindre, caractérisé par le fait qu'il est prévu, en supplément, au moins deux plaques de blindage allongées (20 et 23), qui s'étendent dans deux plans parallèles, qui sont disposées parallèlement et à distance des éléments de blindage en forme de barres (9 à 11) du dispositif de blindage (2) et font saillie sur une longueur prédéterminée (longueur l'–longueur L) au-delà des extrémités frontales respectives (plaques d'extrémité 5 et 6).

7. Dispositif magnétique suivant la revendication 6, caractérisé par le fait que dans chacun des deux plans parallèles se trouvent disposées au moins deux plaques de blindage (20, 21 ou 22, 23), dont la distance réciproque (a) est adaptée à la largeur correspondante (B) du dispositif de blindage de forme cylindrique (2).

8. Dispositif magnétique suivant la revendication 6, caractérisé par le fait que dans chacun des deux plans parallèles se trouve disposée une plaque de blindage, dont la largeur correspond au moins dans une large mesure à la largeur (B) du dispositif de blindage de forme cylindrique (2).

9. Dispositif magnétique suivant l'une des revendications 6 à 8, caractérisé par le fait que la longueur axiale (l') des plaques de blindage supplémentaires (20 à 23) est égale au moins aux 7/8 de la longueur correspondante (L) du dispositif de blindage de forme cylindrique (2).

10. Dispositif magnétique suivant l'une des revendications 6 à 9, caractérisé par le fait que la longueur axiale (l') des plaques de blindage supplémentaires (20 à 23) est égale au maximum au triple de la longueur correspondante (L) du dispositif de blindage de forme cylindrique (2).

11. Dispositif magnétique suivant l'une des revendications 6, 7, 9 ou 10, caractérisé par le fait que la largeur (b') des plaques de blindage supplémentaires (20 à 23) est comprise entre 0,5 et 1,5 m.

12. Dispositif magnétique suivant l'une des revendications 1 à 11, caractérisé par le fait que l'épaisseur des plaques de blindage supplémentaires (13 à 16; 20 à 23) est comprise entre 1 et 3 cm.

13. Dispositif magnétique suivant l'une des revendications 6 à 12, caractérisé par le fait que l'épaisseur des plaques de blindage supplémentaires (20 à 23) est plus faible dans la zone de leurs extrémités frontales (25) que dans la zone du dispositif de blindage de forme cylindrique (2).

0177869

-84 P 3430-

FIG 1

FIG 2

0177869

84 P 3430

FIG 3

| Nr. | Niveau [mT] |
|-----|-------------|
| 1   | 0.1         |
| 2   | 0.2         |
| 3   | 0.3         |
| 4   | 0.5         |
| 5   | 1.0         |
| 6   | 3.0         |
| 7   | 10.0        |

FIG 4

| Nr. | Niveau [mT] |
|-----|-------------|
| 1 | 0.1 |
| 2 | 0.2 |
| 3 | 0.5 |
| 4 | 1.0 |
| 5 | 2.0 |
| 6 | 5.0 |
| 7 | 10.0 |